# EUROPÄISCHE PATENTSCHRIFT

(11) **EP 4 141 429 B1**
(45) Veröffentlichungstag und Bekanntmachung des Hinweises auf die Patenterteilung: **13.03.2024**
(21) Anmeldenummer: 21192887.4
(22) Anmeldetag: 24.08.2021
(51) Int. Cl.: G01N 23/20025, B01L 3/00

(54) **PROBENZELLE, BELADESTATION, MESSVORRICHTUNG, VERFAHREN ZUM UNTERSUCHEN UND ZUM HERSTELLEN EINES FLACHEN KRISTALLS, VERWENDUNG EINER PROBENZELLE**
SAMPLE CELL, LOADING STATION, MEASURING DEVICE, METHOD FOR INSPECTING AND PRODUCING A FLAT CRYSTAL, USE OF A SAMPLE CELL
CELLULE ÉCHANTILLON, STATION DE CHARGE, DISPOSITIF DE MESURE, PROCÉDÉ D'INSPECTION ET DE FABRICATION D'UN CRISTAL PLAT, UTILISATION D'UNE CELLULE ÉCHANTILLON

(43) Veröffentlichungstag der Anmeldung: 01.03.2023
(73) Patentinhaber: Deutsches Elektronen-Synchrotron DESY, 22607 Hamburg (DE)
(72) Erfinder: MEENTS, Alke, 22607 Hamburg (DE); GÜNTHER, Sebastian, 22763 Hamburg (DE); BARTHELMESS, Miriam, 21075 Hamburg (DE)
(74) Vertreter: Seemann & Partner Patentanwälte mbB

(56) Entgegenhaltungen:
- WO-A1-2016/029200
- US-A1- 2015 338 322
- US-A1- 2017 348 687
- US-A1- 2018 214 863

## Beschreibung

Die Erfindung betrifft eine Probenzelle, umfassend einen flachen Probenraum, eine Beladestation zur Aufnahme einer solchen Probenzelle sowie eine Messvorrichtung zum Untersuchen einer Probe, welche in dem Probenraum einer solchen Probenzelle vorhanden ist. Ferner betrifft die Erfindung ein Verfahren zum Untersuchen sowie ein Verfahren zum Herstellen eines flachen Kristalls. Die Erfindung betrifft ferner die Verwendung einer Probenzelle.

Zur Untersuchung von Proben mittels Elektronendiffraktion ist es erforderlich, sehr dünne Proben bereitzustellen. Die in Strahlrichtung maximale Dicke ist abhängig von der Energie der zur Untersuchung verwendeten Elektronen. Aufgrund der Wechselwirkung der Elektronen mit dem Material der Probe ist es außerdem erstrebenswert, lateral, also quer zu einer Strahlrichtung, flächig möglichst große Proben für die Untersuchung zu verwenden. So kann einerseits ein starkes Diffraktionssignal erhalten werden und es können gleichzeitig mögliche Strahlenschäden durch die Verteilung der Strahlendosis auf ein größeres Volumen reduziert werden. Die Elektronendiffraktion eignet sich vor allem für die Untersuchung von Kristallen, insbesondere Einkristallen. Hierzu sind dünne und zugleich lateral ausgedehnte Kristalle besonders geeignet.

Ein beispielhaftes kommerziell verfügbares System, welches zur Untersuchung von Flüssigkeiten mittels Elektronendiffraktion in einem Transmissionselektronenmikroskop (TEM) vorgesehen ist, wird unter der Bezeichnung "Liquid Cell" von der Firma Norcada angeboten. Dieses System ist auf einen speziell dafür vorgesehenen Probenhalter eines Transmissionselektronenmikroskops abgestimmt. Es besteht aus zwei einzelnen Plättchen, welche als Boden- und Deckelplatte des Systems fungieren und welche in Größe und Form auf den speziellen TEM-Probenhalter angepasst sind. In den Plättchen ist zentral eine Vertiefung vorgesehen, in welche eine Flüssigkeit eingebracht werden kann. Werden zwei solche Plättchen aufeinandergelegt, entsteht eine Kavität, die entlang des Umfangs durch einen zwischen den Plättchen liegenden O-Ring abgedichtet wird. Hierzu ist es erforderlich, dass der TEM-Probenhalter einen Druck auf die Boden- und Deckelplatte ausübt. Eine solche Probenzelle ist also nur in Verbindung mit dem passenden TEM-Probenhalter zu verwenden und kann nicht aus diesem entnommen werden. Die macht die Handhabung der Proben aufwendig und relativ kompliziert. Solche Probenzellen sind auch aus den Dokumenten WO 2016/029200 und US 2017/348687 bekannt.

Es ist eine Aufgabe der Erfindung, eine Probenzelle mit einem flachen Probenraum, eine Beladestation zur Aufnahme einer solchen Probenzelle, eine Messvorrichtung zur Untersuchung einer Probe, welche in dem Probenraum der Probenzelle vorhanden ist, ein Verfahren zum Untersuchen sowie ein Verfahren zum Herstellen eines flachen Kristalls sowie die Verwendung einer solchen Probenzelle anzugeben, wobei die Möglichkeit geschaffen werden soll, bei vereinfachter Handhabung eine flache Probe, insbesondere einen flachen Kristall, in dem Probenraum zur Untersuchung bereitzustellen.

Die Aufgabe wird gelöst durch eine Probenzelle, umfassend zumindest einen flachen Probenraum, welcher an seiner ersten großen Flachseite von einer ersten Innenseite einer ersten Membran und an seiner zweiten großen Flachseite von einer zweiten Innenseite einer zweiten Membran begrenzt ist, wobei zwischen der ersten und der zweiten Innenseite ein Abstandshalter angeordnet ist, der einen Abstand zwischen den beiden Membranen festlegt, und wobei an einer dem Probenraum abgewandten ersten Außenseite der ersten Membran ein erstes Halteelement und an einer dem Probenraum abgewandten zweiten Außenseite der zweiten Membran ein zweites Halteelement angeordnet sind und das erste und zweite Halteelement gemeinsam eine Haltestruktur bilden, wobei das erste und zweite Halteelement jeweils eine Mehrzahl von Durchbrüchen aufweisen, die in einer Richtung quer zu den Flachseiten zueinander fluchtend angeordnet sind, so dass sich eine Mehrzahl von Untersuchungsfenstern ergibt, in denen die Außenseiten der Membranen freiliegen.

Die Probenzelle gemäß Aspekten der Erfindung ist zur Aufnahme einer Flüssigkeit oder auch einer Suspension geeignet. Die Suspension kann beispielsweise kleine Kristalle (Mikrokristallite) umfassen. Insbesondere ist die Probenzelle zur Aufnahme einer kristallisationsfähigen Probenlösung eingerichtet. Der flache Probenraum dient gemäß dieser Ausführungsform als ein flaches Reservoir für die kristallisationsfähige Probenlösung. Aus der kristallisationsfähigen Probenlösung bildet sich innerhalb des flachen Probenraums ein Kristall, bei dem es sich um einen Polykristall, insbesondere um einen Einkristall, handelt.

Die Probenzelle umfasst zumindest einen Probenraum, was bedeutet, dass die Probenzelle einen einzigen oder auch mehrere Probenräume umfasst. Umfasst die Probenzelle mehrere Probenräume können diese auch mit unterschiedlichen Proben beladen werden. Bei diesen Proben kann es sich, wie bereits zuvor erwähnt, wiederum beispielsweise um eine oder mehrere Flüssigkeiten, Suspensionen oder auch kristallisationsfähige Flüssigkeiten handeln.

Der Abstandshalter, welcher den Abstand zwischen den beiden Membranen definiert, ist insbesondere aus mehreren Abstandselementen aufgebaut, welche insbesondere unter Berücksichtigung der mechanischen Stabilität der Probenzelle an verschiedenen Positionen innerhalb des flachen Probenraums angeordnet sind und sich zwischen den Innenseiten der einander gegenüberliegenden Membranen erstrecken. Die in dem ersten und zweiten Halteelement vorhandenen Durchbrüche sind ferner insbesondere in einer Richtung, welche zumindest näherungsweise senkrecht zu den Ebenen verläuft, in denen sich die Flachseiten des Probenraums erstrecken, zueinander fluchtend angeordnet.

Mit der Probenzelle gemäß Aspekten der Erfindung können an der in dem Probenraum vorhandenen Probe vorteilhaft Messungen mittels elektromagnetischer Strahlung durchgeführt werden. Beispielsweise ist die Probenzelle geeignet, um die Probe mittels Röntgenstrahlung oder auch mittels Elektronendiffraktion zu untersuchen. An einer in dem flachen Probenraum vorhandenen Probe, insbesondere einem Kristall, ferner insbesondere einem Einkristall, können also vorteilhaft Röntgenmessungen und/oder Messungen mittels Elektronendiffraktion durchgeführt werden. Insbesondere zur Durchführung der Elektronendiffraktionsmessungen ist es besonders vorteilhaft, dass der Probenraum flach ist, also in Strahlrichtung eine geringe Dicke aufweist. So ist die in dem Probenraum vorhandene Probe gut durchstrahlbar. Um die Durchstrahlbarkeit der Probe zu gewährleisten, ist es vorteilhaft, wenn die Dicke der Probe, also die Abmessung der Probe in Strahlrichtung, an die für die Messung verwendete Wellenlänge oder Energie, insbesondere die Elektronenenergie angepasst wird. Durch die lateral große Ausdehnung des Probenraums ist es außerdem möglich, ein starkes Diffraktionssignal zu erhalten, wobei gleichzeitig mögliche Strahlenschäden durch die Verteilung der Dosis auf ein größeres Probenvolumen reduziert werden können. Dies ist für die Untersuchung von Proben von Vorteil, welche aus organischen Kristallen bestehen, daher also besonders empfindlich gegenüber Strahlenschäden sind. Dieser Vorteil kommt besonders bei Messungen bei Raumtemperatur zum Tragen, da hier deutlich stärkere Strahlenschäden auftreten, als bei Messungen bei tiefen Temperaturen.

Außerdem können mithilfe der Probenzelle gemäß Aspekten der Erfindung zeitaufgelöste Messungen, beispielsweise an beschleunigerbasierten Messeapparaturen, wie beispielsweise Elektronendiffraktionsapparaturen durchgeführt werden. Zeitaufgelöste Messungen erfordern hohe Strahlintensitäten, welche, wie bereits erwähnt, vorteilhaft auf ein großes Probenvolumen verteilt werden können.

Ein weiterer Aspekt, der bei der Elektronendiffraktion zu berücksichtigen ist, ist die Tatsache, dass der Elektronenstrahl aufgrund der gegenseitigen Abstoßung der Elektronen nur mit starkem Verlust der Strahlqualität oder der Intensität auf einen geringen Strahlquerschnitt von wenigen Mikrometern fokussiert werden kann. Daher ist es für die Elektronendiffraktometrie besonders vorteilhaft, wenn lateral große Proben, insbesondere Kristalle, bereitgestellt werden können.

Dabei sollte die laterale Ausdehnung der Probe zumindest dem erreichbaren minimalen Strahlquerschnitt entsprechen. Mit anderen Worten ist also die Probenzelle gemäß Aspekten der Erfindung für die Elektronendiffraktometrie besonders geeignet.

Es ist jedoch nicht nur wichtig, Proben, insbesondere Kristalle, bereitzustellen, deren Ausdehnung lateral, also quer zur Strahlrichtung möglichst groß und in Strahlrichtung gering ist. Auch das Probensubstrat, in diesem Fall also die Probenzelle, sollte nach Möglichkeit dazu beitragen, ein starkes Diffraktionssignal ohne zu großen, den Messwert beeinflussenden und damit störenden Untergrund zu ermöglichen. Zu diesem Zweck weist die Probenzelle gemäß Aspekten der Erfindung Untersuchungsfenster auf, in denen der Probenraum gegenüber der Umgebung lediglich durch die zu beiden Seiten vorhandenen Membranen begrenzt ist. Mit anderen Worten hat also die Haltestruktur in diesen Bereichen nur einen minimalen Einfluss auf das erzielbare Messsignal.

Die Probenzelle gemäß Aspekten der Erfindung erfüllt nicht nur die Voraussetzungen, um Messungen in hoher Qualität durchzuführen, sie ist auch sehr leicht handhabbar. Dies wird insbesondere erreicht, indem die gesamte Probenzelle als ein einziges integrales Bauteil ausgestaltet ist. Es ist beispielsweise bei der Beladung der Probenzelle nicht erforderlich, diese aus mehreren Einzelteilen zusammenzusetzen. Auch ist es während der Messung nicht erforderlich, die Probenzelle in einem speziell dafür vorgesehenen Halter zu verwenden. Die erste Bedingung kann gemäß einer weiteren Ausführungsform dadurch erfüllt werden, dass der Abstandshalter derart dimensioniert wird, dass die Innenseiten der Membranen einen solchen Abstand zueinander aufweisen, dass Probenflüssigkeit durch Kapillarkräfte in den Probenraum hineinsaugbar sind. Die zweite Bedingung kann gemäß einer weiteren Ausführungsform dadurch erfüllt werden, dass die Haltestruktur derart dimensioniert wird, dass die Probenzelle in ihrer Gesamtheit eigenstabil ist. Letzteres qualifiziert die Probenzelle insbesondere für voll- oder teilautomatisierte Messungen. Beispielsweise ist es möglich, die Probenzelle problemlos mithilfe eines Roboters zu handhaben. Die Probenzelle ist außerdem für Anwendungen geeignet, in denen diese als Flüssigkeitszelle eingesetzt wird. Zu diesem Zweck ist der flache Probenraum mit der zu untersuchenden Flüssigkeit oder einer Suspension gefüllt.

Gemäß einer vorteilhaften Ausführungsform ist die Probenzelle fortgebildet, indem die erste Innenseite der ersten Membran mit dem Abstandshalter, die erste Außenseite der ersten Membran mit dem ersten Halteelement, die zweite Innenseite der zweiten Membran mit dem Abstandshalter und die zweite Außenseite der zweiten Membran mit dem zweiten Halteelement stoffschlüssig, insbesondere vakuumdicht, verbunden sind.

Die stoffschlüssige Verbindung zwischen den genannten Bauteilen erfolgt beispielsweise hilfsstofffrei, d.h. die Bauteile werden direkt stoffschlüssig miteinander verbunden, ohne dass hierzu Hilfsstoffe, wie beispielsweise ein geeigneter Klebstoff oder dergleichen, eingesetzt wird. Die hilfsstofffreie stoffschlüssige Verbindung kann beispielsweise realisiert werden, indem die miteinander zu verbindenden Bauteile durch Anwendung geeigneter mechanischer Drücke aufeinandergepresst werden. Dabei können die Bauteile auch unter den Fügeprozess unterstützender Hitzeeinwirkung miteinander verbunden werden. Beispielsweise wird eine stoffschlüssige Verbindung durch Interdiffusionen der beteiligten Materialien erreicht. Es ist jedoch ebenso vorgesehen, die vorgenannten Bauteile unter Verwendung zumindest eines Hilfsstoffs stoffschlüssig miteinander zu verbinden. Beispielsweise werden die Bauteile unter Verwendung eines geeigneten Klebstoffs miteinander verbunden.

Durch die stoffschlüssige Verbindung kann die Probenzelle insbesondere derart ausgestaltet werden, dass diese vakuumdicht ist. Die stoffschlüssigen Verbindungen der einzelnen Bauteile werden also mit anderen Worten derart ausgelegt, dass die geforderte Vakuumdichtigkeit erzielt wird. Indem die Probenzelle vakuumdicht ausgeführt wird, qualifiziert sich diese besonders für den Einsatz im Zusammenhang mit Elektronendiffraktionsmessungen, welche typischerweise unter Vakuumbedingungen durchgeführt werden. Gleichzeitig können in dem Probenraum der Probenzelle Probenmaterialien untersucht werden, welche keinen Vakuumbedingungen ausgesetzt werden können, beispielsweise organische Proben, insbesondere Proben, welche in feuchter Umgebung vorliegen oder vorliegen müssen.

Gemäß einer weiteren vorteilhaften Ausführungsform umfasst die Probenzelle ferner ein Dichtelement, welches sich zwischen der ersten Innenseite der ersten Membran und der zweiten Innenseite der zweiten Membran in einem Randbereich erstreckt und den Probenraum gegenüber einem Außenraum abschließt, wobei das Dichtelement zumindest eine Zugangsöffnung freilässt, durch die der zumindest eine Probenraum befüllbar ist.

Das Dichtelement ist ferner insbesondere als ein Teil des Abstandshalters ausgebildet. Insbesondere ist das Dichtelement mit der ersten Innenseite der ersten Membran und mit der zweiten Innenseite der zweiten Membran stoffschlüssig, insbesondere vakuumdicht, verbunden. Ferner insbesondere ist die zumindest eine Zugangsöffnung stoffschlüssig, insbesondere vakuumdicht, verschlossen.

Die Zugangsöffnung wird beispielsweise mittels eines geeigneten Klebstoffs verschlossen. Anschließend ist die Probenzelle für Vakuumanwendungen geeignet. Für Anwendungen unter Atmosphärendruck und bei zeitnaher Messung, kann auf das vollständig vakuumdichte Abdichten der Probenzelle ggf. verzichtet werden. Dies beschleunigt den gesamten Messvorgang, der die Probenpräparation einschließt.

Die Dimensionen des flachen Probenraums, insbesondere die durch die Abstandshalter bestimmte Dicke des flachen Probenraums, werden vorteilhaft so gewählt, dass eine Probenlösung oder Suspension durch Kapillarkräfte in den Probenraum gesogen wird, sobald die zumindest eine Zugangsöffnung der Probenzelle mit der Probenlösung oder Suspension im fluidischen Kontakt steht. Zu diesem Zweck wird beispielsweise die Probenzelle so weit in eine Probenlösung oder Suspension eingetaucht, dass die zumindest eine Zugangsöffnung unterhalb eines Flüssigkeitsspiegels der Flüssigkeit liegt. Wiederum ist es in diesem Zusammenhang besonders vorteilhaft, dass die Probenzelle im Gegensatz zu herkömmlichen Probenzellen eigenstabil ist, d. h. insbesondere ohne einen speziell dafür vorgesehenen Halter verwendbar, transportierbar und auch verwahrbar ist.

Die aus dem Stand der Technik bekannte Probenzelle des Herstellers Norcada ist aus zwei einzelnen separaten Plättchen aufgebaut, von denen eines als Boden und ein weiteres als Deckel fungiert. Zusammen mit dem dazwischenliegenden Dichtring müssen diese beiden Plättchen in einem speziellen Halter eingeklemmt werden, der anschließend auch zwingend für die Messung verwendet werden muss. Mit einem solchen System ist es so nicht möglich, mehrere Proben gleichzeitig für eine anschließende Messung vorzubereiten, es sei denn, es würde der große finanzielle Aufwand betrieben, für jede Probe einen separaten Halter zu verwenden. Soll in einer solchen Probenzelle eine Kristallisation einer kristallisationsfähigen Probenlösung durchgeführt werden, erweist sich das System aus den vorgenannten Gründen als denkbar ungeeignet. Die Probenzelle gemäß Aspekten der Erfindung beseitigt vorteilhaft diese im Stand der Technik vorhandenen technischen und wirtschaftlichen Nachteile.

Die Probenzelle gemäß Aspekten der Erfindung weist insbesondere einen ersten Halter und einen zweiten Halter auf, die jeweils aus einer Mehrzahl von Stegen aufgebaut sind. Diese Stege sind beispielsweise in einem regelmäßigen Raster angeordnet. Zwischen benachbarten Stegen befinden sich die Durchbrüche des Halteelements. Bevorzugt sind ein erstes und ein zweites Halteelement als Haltestruktur vorgesehen, welche eine zumindest näherungsweise identische Struktur aufweisen. So ist es möglich, die in den Halteelementen vorhandenen Durchbrüche mit geringem Aufwand zueinander fluchtend anzuordnen. Die Halteelemente weisen insbesondere eine regelmäßige Struktur auf, welche beispielsweise derart ausgestaltet ist, dass die in dem Halteelement vorhandenen Durchbrüche in einem Raster angeordnet sind. Beispielsweise sind die Durchbrüche in zwei zueinander zumindest näherungsweise senkrechten Rasterrichtungen angeordnet, beispielsweise in einem quadratischen Raster. Dies hat den Vorteil, dass die einzelnen Untersuchungsfenster bei einer voll- oder teilautomatisierten Messung mit geringem Aufwand angefahren werden können. Beispielsweise kann ein zur Messung eingesetzter Probentisch die Probenzelle mit konstanter Schrittweite in einem Raster verfahren.

Gemäß einer weiteren vorteilhaften Ausführungsform ist vorgesehen, dass der Abstandshalter, betrachtet in einer Richtung quer zu den großen Flachseiten, eine konstante Materialstärke aufweist, so dass die Innenseiten der Membranen zumindest näherungsweise planparallel zueinander angeordnet sind. Die Untersuchung einer Probe mit konstanter Probendicke hat den Vorteil, dass die in den einzelnen Untersuchungsfenstern durchgeführten Messungen leicht miteinander vergleichbar sind.

Gemäß einer weiteren vorteilhaften Ausführungsform ist die Probenzelle dadurch fortgebildet, dass deren zumindest einer Probenraum ein Aspektverhältnis zwischen einer lateralen Ausdehnung, gemessen in einer Richtung zumindest näherungsweise parallel zu den gro-ßen Flachseiten, und einer Dicke, gemessen in einer Richtung zumindest näherungsweise senkrecht zu den großen Flachseiten, von zumindest 10 zu 1 oder größer aufweist. Die Ausdehnung des zumindest einen Probenraums ist also betrachtet in eine Richtung zumindest näherungsweise parallel zu den großen Flachseiten zumindest zehnmal so groß wie die Ausdehnung des zumindest einen Probenraums in eine Richtung senkrecht dazu. Der zumindest eine Probenraum weist ferner insbesondere ein wesentlich größeres Aspektverhältnis auf, beispielsweise von 20 zu 1, ferner beispielsweise von 100 zu 1 oder auch von 1000 zu 1. die zuvor genannten Aspektverhältnisse haben sich in der Praxis als vorteilhaft herausgestellt. Es wird eine Probe bereitgestellt, welche eine laterale Ausdehnung hat, die groß genug ist, um eine ausreichende Anzahl von Messpunkten bei gegebener Probendicke bereitzustellen.

Gemäß einer weiteren vorteilhaften Ausführungsform weist die Probenzelle einen Probenraum auf, dessen laterale Ausdehnungen, gemessen in einer Richtung zumindest näherungsweise parallel zu den großen Flachseiten, zwischen 100 µm und 100 mm beträgt und deren Probenraum eine Dicke, gemessen in einer Richtung zumindest näherungsweise senkrecht zu den großen Flachseiten, zwischen 1 nm und 10 µm aufweist. Eine solche Probenzelle mit den genannten Abmessungen hat sich in der Praxis für die Anwendung in der Elektronendiffraktion als besonders vorteilhaft erwiesen.

Die Dicke des zumindest einen Probenraums ist von der Energie der zu Messung verwendeten elektromagnetischen Strahlung oder der Elektronenenergie abhängig. Gemäß weiterer Ausführungsformen hat es sich als vorteilhaft erwiesen, wenn die Probenzelle so ausgestaltet ist, dass ihr Probenraum eine Dicke von kleiner oder gleich 800 nm aufweist. Eine solche Probenzelle ist zur Messung mittels eines Elektronenstrahls, der eine Energie von zumindest näherungsweise 3 MeV aufweist, besonders geeignet. Insbesondere weist die Probenzelle einen Probenraum mit einer Dicke zwischen 500 nm und 1 µm auf. Eine solche Probenzelle ist besonders gut für Messungen geeignet, bei denen die Elektronenenergie zwischen 2 und 3 MeV liegt. Gemäß einer weiteren Ausführungsform weist der Probenraum der Probenzelle eine Dicke von kleiner oder gleich 300 nm auf. Eine solche Probenzelle ist besonders geeignet für Elektronendiffraktionsmessungen, die bei einer Energie von 300 keV durchgeführt werden.

Um die Dicke des Probenraums entsprechend einzustellen, weist die Probenzelle gemäß den vorgenannten Ausführungsformen einen Abstandshalter auf, welcher beispielsweise zumindest näherungsweise 800 nm hoch ist. Der Abstandshalter ist gemäß den weiteren genannten Ausführungsformen so ausgestaltet, dass dieser eine Höhe zwischen 500 nm und 1 µm aufweist. Um einen besonders flachen Probenraum zu realisieren, ist vorgesehen, dass gemäß der weiteren Ausführungsform der Abstandshalter eine Höhe von kleiner oder gleich 300 nm aufweist.

Gemäß weiterer Ausführungsformen liegt die Materialstärke oder Höhe des Abstandshalters zwischen 100 nm und 1 µm, ferner insbesondere unterhalb von 300 nm oder unterhalb von 500 nm. Ferner insbesondere ist vorgesehen, dass der Abstandshalter eine Materialstärke aufweist, die zwischen 500 nm und 1 µm liegt.

Der Abstandshalter ist beispielsweise aus einem Metall, insbesondere aus Gold, hergestellt. Gemäß einer weiteren Ausführungsform kann auch Fotolack oder ein geeignetes Polymer als Abstandshalter eingesetzt werden.

Die Haltestruktur der Probenzelle ist gemäß einer weiteren Ausführungsform mit einer Materialstärke von kleiner oder gleich 200 µm ausgeführt. Insbesondere liegt die Materialstärke der Haltestruktur zwischen 100 µm und 200 µm. In diesem Zusammenhang wird die Materialstärke jeweils eines einzelnen Halteelements, also des ersten oder des zweiten Halteelements, welche gemeinsam die Haltestruktur bilden, betrachtet. Die Halteelemente sind beispielsweise aus Silizium hergestellt. Die Strukturierung der Halteelemente kann mittels Verfahren und Techniken erfolgen, wie sie zur Strukturierung von Silizium technisch allgemein bekannt und üblich sind. Ein typisches Verfahren zur Strukturierung von Silizium ist beispielsweise die Photolithographie.

Die Membran der Probenzelle ist gemäß weiterer Ausführungsformen beispielsweise aus Siliziumnitrid (SiN), aus Graphen, aus amorphem Kohlenstoff, aus Silizium (Si), aus Bornitrid (BN) oder einem Polymer hergestellt. Die Membran weist vorteilhaft eine Materialstärke auf, die im Bereich zwischen 1 nm und 100 nm liegt. Für Siliziumnitrid (SiN) hat sich eine Materialstärke zwischen 30 nm und 100 nm als vorteilhaft erwiesen.. Eine Membran aus den vorgenannten Materialen und mit der vorgenannten Materialstärke hat den Vorteil, dass diese zum großen Teil elektronentransparent ist, was für den Einsatz der Probenzelle in der Elektronendiffraktometrie besonders vorteilhaft ist.

Gemäß einer weiteren Ausführungsform ist vorgesehen, dass die Untersuchungsfenster eine laterale Abmessung aufweisen, die zwischen 10 µm und 200 µm liegt. Diese Abmessung wird in einer Richtung zumindest näherungsweise parallel zu den großen Flachseiten gemessen. Eine Probenzelle mit derartigen Untersuchungsfenstern ist für die Elektronendiffraktion besonders geeignet, da sich aufgrund der gegenseitigen Abstoßung der Elektronen der Elektronenstrahl nicht beliebig fokussieren lässt.

Die zuvor genannten lateralen Abmessungen, sowohl für den zumindest einen Probenraum als auch für das Untersuchungsfenster sind beispielsweise maximale Kantenlängen, soweit es sich bei den betrachteten Gegenständen (Probenraum, Untersuchungsfenster) um rechteckige oder quadratische Geometrien handelt. Für runde oder ovale Geometrien wird ein maximaler Durchmesser betrachtet. Für alle übrigen Geometrien wird unter der Abmessung eine maximale Ausdehnung oder Länge verstanden.

Die Aufgabe wird ferner gelöst durch eine Beladestation zur Aufnahme zumindest einer Probenzelle nach einem oder mehreren der zuvor genannten Ausführungsformen, wobei die Beladestation ein Präparationsreservoir und einen Probenzellenhalter umfasst, und wobei das Präparationsreservoir geodätisch tiefer angeordnet ist als der Probenzellenhalter, der dazu eingerichtet ist, die zumindest eine Probenzelle derart aufzunehmen, dass ein fluidischer Kontakt zwischen einem Teilbereich der Probenzelle und dem Präparationsreservoir herstellbar ist.

Vorteilhaft wird die Möglichkeit geschaffen, dass eine in dem Präparationsreservoir anordnenbare Probenflüssigkeit oder Suspension durch Kapillarkräfte in die zumindest eine Probenzelle hineingesogen werden kann. Dieser Vorgang erfolgt binnen einer relativ kurzen Zeitspanne, die im Bereich von Sekunden oder maximal Minuten liegt.

Mit der Beladestation gemäß Aspekten der Erfindung kann das Beladen der zumindest einen Probenzelle vorgenommen werden, ohne dass hierzu der Eingriff einer das Experiment durchführenden Person erforderlich ist. So ist es insbesondere mithilfe mehrerer solcher Beladestationen problemlos möglich, eine große Anzahl von Probenzellen gleichzeitig zu beladen und für die anschließende Messung vorzubereiten. Außerdem kann in dem Präparationsreservoir die gewünschte Probenlösung oder Suspension vorbereitet werden.

Die Beladestation weist gemäß einer Ausführungsform an seiner Unterseite eine Standfläche auf, mit der diese auf einer zumindest näherungsweise ebenen Oberfläche aufgestellt werden kann. Der Probenzellenhalter ist so angeordnet, dass er die zumindest eine Probenzelle derart gegenüber dem Präparationsreservoir hält, dass die Kapillarkräfte entgegen der Schwerkraftwirkung die Probenflüssigkeit oder Suspension in den Probenraum saugen.

Gemäß weiterer Ausführungsformen ist der Probenzellenhalter so ausgestaltet, dass er die Probenzelle beispielsweise in einer Orientierung aufnimmt, sodass die Probenzelle zumindest näherungsweise senkrecht zu einer Ebene der Standfläche orientiert ist. Die Orientierung der Probenzelle bezieht sich auf die Ebenen, in denen sich die den Probenraum begrenzenden Membranen erstrecken. Der Probenzellenhalter ist gemäß weiterer Ausführungsformen so ausgestaltet, dass zumindest eine der Probenzellen schräg, beispielsweise unter einem Winkel zwischen 0° und 60° zu der zuvor beschriebenen senkrechten Orientierung ausgerichtet ist. Beispielsweise schließt also eine Ebene, in der sich die den Probenraum begrenzenden Membranen erstrecken mit der senkrechten Orientierung einen Winkel von 45° ein.

Gemäß einer weiteren Ausführungsform ist die Beladestation dadurch fortgebildet, dass sie zur Aufnahme einer Probenzelle eingerichtet ist, welche ein Dichtelement umfasst, welches sich zwischen der ersten Innenseite der ersten Membran und der zweiten Innenseite der zweiten Membran in einem Randbereich erstreckt und den Probenraum gegenüber einem Außenraum abschließt, wobei das Dichtelement zumindest eine Zugangsöffnung frei lässt, durch die der Probenraum befüllbar ist. Eine solche Beladestation umfasst einen Probenzellenhalter, der dazu eingerichtet ist, die Probenzelle derart aufzunehmen, dass zwischen der Zugangsöffnung der Probenzelle und dem Präparationsreservoir ein fluidischer Kontakt herstellbar ist.

Beispielsweise ist der Probenzellenhalter so ausgestaltet, dass er eine Probenzelle mit quadratischer Grundfläche so aufnimmt, dass die Probenzelle entlang einer ihrer Seitenkanten in Kontakt mit dem Präparationsreservoir steht. Ist die zumindest eine Zugangsöffnung der Probenzelle an dieser Seitenkante vorhanden, kann die Probenflüssigkeit oder Suspension über die zumindest eine Zugangsöffnung in den Probenraum durch Kapillarkräfte eingesogen werden.

Die Aufgabe wird ferner gelöst durch eine Messvorrichtung zum Untersuchen einer Probe, welche in dem zumindest einen Probenraum einer Probenzelle vorhanden ist, die nach einem oder mehreren der zuvor in Bezug auf die Probenzelle beschriebenen Ausführungsformen ausgestaltet ist. Diese Messvorrichtung umfasst eine Strahlungsquelle, beispielsweise eine elektromagnetische Strahlungsquelle oder eine Elektronenquelle, welche einen Messstrahl emittiert, der auf einen Teilbereich der Probenzelle gerichtet ist, wobei die Messvorrichtung ferner einen Detektor zur Erfassung einer Messung, insbesondere zum Messen eines Elektronenbeugungsbildes, umfasst.

Wie bereits zuvor erwähnt, ist die Probenzelle zur Durchführung von Röntgenmessungen oder Elektronendiffraktionsmessungen besonders geeignet. In der genannten Messvorrichtung ergänzen sich vorteilhaft die Eigenschaften der Probenzelle mit der Art der durchgeführten Messung.

Die Messvorrichtung ist gemäß einer weiteren Ausführungsform vorteilhaft dadurch fortgebildet, dass diese einen Probenhalter zur Aufnahme der Probenzelle und eine Verarbeitungseinheit umfasst, welche dazu eingerichtet ist, den Probenhalter derart zu verfahren, dass mittels des Messstrahls die Probe an voneinander verschiedenen Bereichen in jeweils einem Untersuchungsfenster der Probenzelle messbar ist, wobei insbesondere die Verarbeitungseinheit dazu eingerichtet ist, den Probenhalter derart zu verfahren, dass der Messstrahl nacheinander auf verschiedene Untersuchungsfenster der Probenzelle trifft.

Mit einer solchen Messvorrichtung können vorteilhaft Proben untersucht werden, welche im Hinblick auf mögliche beispielsweise von dem verwendeten Elektronenstrahl verursachte Strahlenschäden sensibel sind. Dies betrifft beispielsweise Kristalle, insbesondere Einkristalle, aus organischem oder biologischem Material. Indem die Messungen in verschiedenen Untersuchungsfenstern durchgeführt werden, kann die Strahlendosis auf ein großes Probenvolumen verteilt werden.

Die Aufgabe wird ferner gelöst durch ein Verfahren zum Untersuchen einer flachen Probe, wobei das Verfahren die folgenden Schritte umfasst:
a) Bereitstellen einer Probenzelle nach einer oder mehreren der zuvor genannten Ausführungsformen,
b) Verbringen einer Probenlösung oder Suspension in den zumindest einen Probenraum der Probenzelle,
c) Verbringen der Probenzelle, welche die flache Probe in dem zumindest einen Probenraum umfasst, in eine Messvorrichtung, umfassend eine Strahlungsquelle, insbesondere eine Elektronenquelle, welche einen Messstrahl emittiert,
d) Ausrichten der Probenzelle in Bezug auf den Messstrahl, so dass dieser zumindest einen Teil der Probe, die in einen Teilbereich des Probenraums der Probenzelle vorhanden ist, durchstrahlt, und
e) Aufnehmen einer Messung, insbesondere eines Elektronenbeugungsbildes, der Probe.

Auf das Verfahren zum Untersuchen einer flachen Probe treffen gleiche oder ähnliche Vorteile zu, wie sie bereits zuvor im Hinblick auf die Probenzelle erwähnt wurden, sodass auf Wiederholungen verzichtet werden soll.

Gemäß einer vorteilhaften Ausführungsform ist das Verfahren zum Untersuchen eines flachen Kristalls als Probe dadurch fortgebildet, dass
in Schritt b) eine kristallisationsfähige Probenlösung in den Probenraum der Probenzelle verbracht wird,
das Verfahren zusätzlich den nach Schritt b) auszuführenden Schritt b1) umfasst:
   b1) Verbringen der gefüllten Probenzelle in einen Kristallisationsraum und Bereitstellen von Umgebungsbedingungen in dem Kristallisationsraum, die eine Kristallbildung in der kristallisationsfähigen Probenlösung begünstigen.

Als Umgebungsbedingungen, die eine Kristallbildung begünstigen, werden in dem Kristallisationsraum beispielsweise eine Feuchtigkeit und/oder eine Temperatur und/oder ein Druck eingestellt.

Das Verfahren zum Untersuchen eines flachen Kristalls ist besonders effizient, da sich unter Anwendung der genannten Verfahrensschritte mithilfe der Probenzelle flache Kristalle in dem Probenraum bereitstellen lassen.

Die Aufgabe wird ferner gelöst durch ein Verfahren zum Herstellen eines flachen Kristalls, insbesondere eines Einkristalls, die folgenden Schritte umfassend: Bereitstellen einer Probenzelle nach einem oder mehreren der zuvor genannten Ausführungsformen, Verbringen einer kristallisationsfähigen Probenlösung in den Probenraum der Probenzelle, Verbringen der gefüllten Probenzelle in einen Kristallisationsraum und Bereitstellen von Umgebungsbedingungen in dem Kristallisationsraum, die eine Kristallbildung in der kristallisationsfähigen Probenlösung begünstigen, nachdem sich der Kristall, insbesondere der Einkristall, in dem Probenraum gebildet hat, Entfernen der ersten und/oder der zweiten Membran einschließlich des zugehörigen Halteelements und Entnehmen des Kristalls aus dem geöffneten Probenraum.

Mit herkömmlichen Mitteln ist es vielfach technisch äußerst aufwendig, flache Kristalle, insbesondere Einkristalle, aus einer Flüssigkeit zu züchten. Wenn gleichzeitig noch die Bedingung erfüllt sein soll, dass der gezüchtete Kristall hohe Anforderungen im Hinblick auf eine homogene Dicke erfüllen soll, sind herkömmliche Verfahren vielfach technisch vollkommen ungeeignet. Mit anderen Worten können mit herkömmlichen Mitteln nur mit großem Aufwand Kristalle gezüchtet werden, welche flach sind und eine konstante Dicke aufweisen. Diese Nachteile werden mit dem genannten Verfahren, welches die Beladestation gemäß Aspekten der Erfindung einsetzt, vorteilhaft überwunden.

Schließlich wird die Aufgabe gelöst durch die Verwendung einer Probenzelle nach einem oder mehreren der zuvor genannten Ausführungsformen zum Züchten eines flachen Kristalls, insbesondere eines Einkristalls, in dem Probenraum der Probenzelle. Auf die Verwendung der Probenzelle treffen gleiche oder ähnliche Vorteile zu, wie sie bereits im Hinblick auf die Probenzelle selbst zuvor erwähnt wurden.

Weitere Merkmale der Erfindung werden aus der Beschreibung erfindungsgemäßer Ausführungsformen zusammen mit den Ansprüchen und den beigefügten Zeichnungen ersichtlich.

Im Rahmen der Erfindung sind Merkmale, die mit "insbesondere" oder "vorzugsweise" gekennzeichnet sind, als fakultative Merkmale zu verstehen.

Die Erfindung wird nachstehend anhand von Ausführungsbeispielen unter Bezugnahme auf die Zeichnungen beschrieben, wobei bezüglich aller im Text nicht näher erläuterten erfindungsgemäßen Einzelheiten ausdrücklich auf die Zeichnungen verwiesen wird. Es zeigen:
- Fig. 1:: einen schematisch vereinfachten Querschnitt durch eine Probenzelle,
- Fig. 2:: eine schematisch vereinfachte Draufsicht auf eine Probenzelle,
- Fig. 3:: eine schematisch vereinfachte Detailansicht der in Fig. 2 in Draufsicht gezeigten Probenzelle,
- Fig. 4:: eine schematisch vereinfachte perspektivische Darstellung einer Beladestation zur Aufnahme einer Probenzelle,
- Fig. 5:: eine schematisch vereinfachte Seitenansicht einer Beladestation mit eingesetzter Probenzelle und
- Fig. 6:: eine Messvorrichtung zum Untersuchen einer Probe, die in dem Probenraum einer Probenzelle vorhanden ist in einer stark vereinfachten und schematischen Darstellung.

In den Zeichnungen sind jeweils gleiche oder gleichartige Elemente und/oder Teile mit denselben Bezugsziffern versehen, so dass von einer erneuten Vorstellung jeweils abgesehen wird.

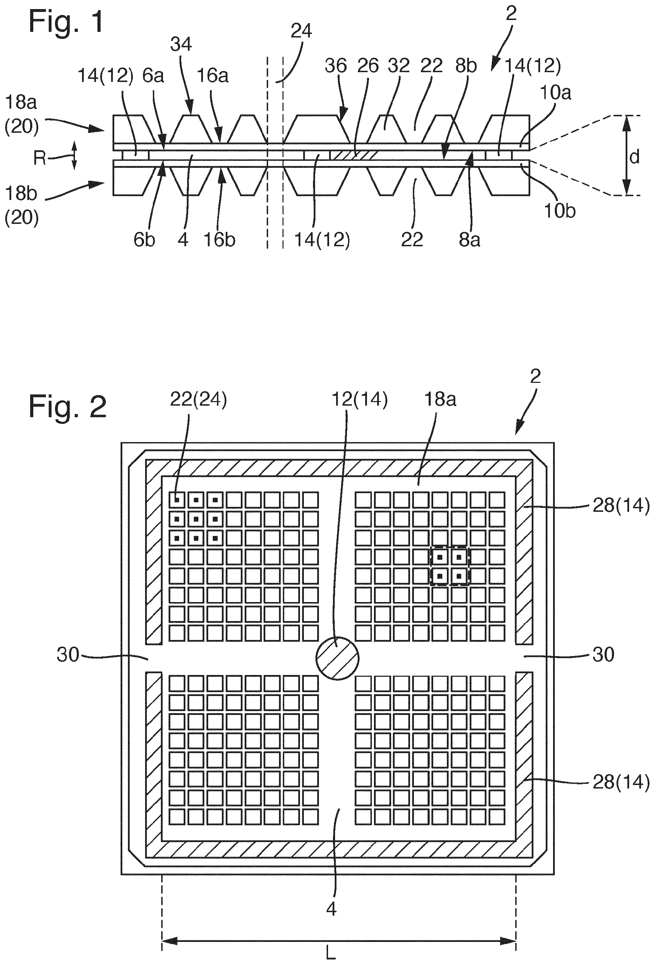

Fig. 1 zeigt in einer schematisch vereinfachten Schnittansicht eine Probenzelle 2, die einen flachen Probenraum 4 umfasst. Die Probenzelle 2 umfasst in der Darstellung von Fig. 1 beispielhaft einen einzigen Probenraum 4. Gemäß weiterer nicht in den Figuren dargestellter Ausführungsbeispiele umfasst die Probenzelle 2 mehr als einen einzigen Probenraum 4. Lediglich beispielhaft wird im Kontext der folgenden Beschreibung auf eine Probenzelle 2 Bezug genommen, welche einen einzigen Probenraum 4 umfasst. Der flache Probenraum 4 ist an seiner ersten großen Flachseite 6a von einer ersten Innenseite 8a einer ersten Membran 10a begrenzt. An seiner zweiten großen Flachseite 6b ist der Probenraum 4 von einer zweiten Innenseite 8b einer zweiten Membran 10b begrenzt. Zwischen der ersten Innenseite 8a und der zweiten Innenseite 8b erstreckt sich ein Abstandshalter 12, der im dargestellten Ausführungsbeispiel aus mehreren Abstandselementen 14 aufgebaut ist. Mit anderen Worten bilden die Abstandselemente 14 gemeinsam den Abstandshalter 12. Der Abstandshalter 12 definiert einen Abstand d zwischen der ersten Membran 10a und der zweiten Membran 10b.

An einer dem Probenraum 4 abgewandten ersten Außenseite 16a der ersten Membran 10a ist ein erstes Halteelement 18a angeordnet. An einer dem Probenraum 4 ebenfalls abgewandten zweiten Außenseite 16b der zweiten Membran 10b ist ein zweites Halteelement 18b angeordnet. Das erste Halteelement 18a und das zweite Halteelement 18b bilden gemeinsam eine Haltestruktur 20 der Probenzelle 2. Diese Haltestruktur 20 ist beispielsweise so ausgelegt, dass die Probenzelle 2 eigenstabil ist.

Das erste Halteelement 18a und das zweite Halteelement 18b umfassen jeweils eine Mehrzahl von Durchbrüchen 22. Aus Gründen der Übersichtlichkeit ist jeweils nur ein Durchbruch 22 in dem jeweiligen Halteelement 18a, 18b mit einem Bezugszeichen versehen. Die Durchbrüche 22 des ersten und zweiten Halteelements 18a, 18b sind in einer Richtung R quer zu den Flachseiten 6a, 6b zueinander fluchtend angeordnet. So ergibt sich eine Mehrzahl von Untersuchungsfenstern 24, in denen die Außenseiten 16a, 16b der Membranen 10a, 10b freiliegen.

Im Bereich des Untersuchungsfensters 24 ist die Probenzelle 2 gut durchstrahlbar. Dies dient zur Untersuchung einer in dem Probenraum 4 vorhandenen und nur bereichsweise durch Schraffur angedeuteten Probe 26, bei der es sich beispielsweise um einen Kristall, ferner beispielsweise um einen Einkristall handelt. Die Probenzelle 2 ist besonders gut für die Untersuchung der Probe 26 mittels Elektronendiffraktometrie geeignet. Ebenso eignet sich die Probenzelle 2 zur Untersuchung der Probe 26 mittels elektromagnetischer Strahlung, beispielsweise Röntgenstrahlung. Im Bereich der Untersuchungsfenster 24 wird die Probe 26 vom Außenraum lediglich durch die Membranen 10a, 10b getrennt. Für die Membranen 10a, 10b wird ein Material gewählt, welches weitgehend für die verwendete elektromagnetische Strahlung bzw. elektronentransparent ist. wird die Messung mittels Elektronenstrahlung durchgeführt, eignet sich als Material für die Membranen 10a, 10b beispielsweise Graphen, Bornitrid oder dergleichen. Die Probenzelle 2 weist eine Vielzahl von Untersuchungsfenstern 24 auf. Dies ist besonders vorteilhaft für eine Untersuchung der Probe 26 mit hoher Strahlungsdosis. Die Strahlungsdosis kann auf ein großes Probenvolumen verteilt werden, indem beispielsweise zeitlich nacheinander einzelne Untersuchungsfenster 24 bestrahlt und die Probe 26 in diesem Bereich vermessen wird. Strahlenschäden an der Probe 26 lassen sich auf diese Weise verringern.

Untersuchungen mittels Elektronendiffraktometrie finden in vielen Fällen unter Vakuumbedingungen statt. Nun ist nicht jede Probe 26 ohne Weiteres vakuumtauglich. Aus diesem Grund ist die Probenzelle 2 gemäß einem Ausführungsbeispiel vakuumdicht ausgeführt. Um dies zu erreichen, ist die erste Innenseite 8a der ersten Membran 10a mit dem Abstandshalter 12, zumindest mit einem Teil der den Abstandshalter 12 bildenden Abstandselemente 14, stoffschlüssig verbunden. Die zweite Innenseite 8b der zweiten Membran 10b ist ebenso stoffschlüssig mit dem Abstandshalter 12, zumindest mit einem Teil der den Abstandshalter 12 bildenden Abstandselemente 14, verbunden. Um die Stabilität der Probenzelle 2 zu verbessern, kann auch die erste Außenseite 16a der ersten Membran 10a mit dem ersten Halteelement 18a stoffschlüssig verbunden sein. Dies gilt ebenso für das zweite Halteelement 18b, welches mit der zweiten Außenseite 16b der zweiten Membran 10b stoffschlüssig verbunden sein kann. Eine stoffschlüssige Verbindung wird beispielsweise durch Anwendung eines geeigneten Drucks auf die beteiligten Elemente erreicht. Die stoffschlüssige Verbindung kann hilfsstofffrei oder unter Verwendung eines oder mehrerer Hilfsstoffe erfolgen. Eine hilfsstofffreie Verbindung erfolgt beispielsweise durch zumindest geringe Interdiffusion der Materialien ineinander oder durch formschlüssige Anpassung auf mikroskopischer Ebene. Hilfsstoffe, welche zur Herstellung einer stoffschlüssigen Verbindung geeignet sind, sind beispielsweise vakuumfeste Klebstoffe, wie Epoxidharze oder dergleichen.

Fig. 2 zeigt in einer schematisch vereinfachten Draufsicht eine Probenzelle 2 gemäß einem weiteren Ausführungsbeispiel. Die Probenzelle 2 umfasst ein Dichtelement 28, welches zweiteilig ausgeführt ist und die Funktion eines Abstandselements 14 erfüllt. Ein weiteres Abstandselement 14 ist zentral in dem Probenraum 4 angeordnet. Dieser wird von dem Dichtelement 28 umschlossen. Das Dichtelement 28 erstreckt sich ebenso wie dies für die Abstandselemente 14 in Fig. 1 gezeigt ist, zwischen der ersten Innenseite 8a der ersten Membran 10a und der zweiten Innenseite 8b der zweiten Membran 10b. Das Dichtelement 28 ist in einem Randbereich der Probenzelle 2 angeordnet und schließt den Probenraum 4 gegenüber einem Außenraum ab. Im dargestellten Ausführungsbeispiel lässt das Dichtelement 28 zwei Zugangsöffnungen 30 frei, durch die der Probenraum 4 befüllbar ist.

In der Draufsicht von Fig. 2 ist lediglich das erste Halteelement 18a sichtbar. Es ist in Bezug auf das Dichtelement 28 und das zentrale Abstandselement 14, welche darunterliegen, teiltransparent dargestellt. In dem ersten Halteelement 18a befinden sich in einem regelmäßigen Raster angeordnet die Durchbrüche 22, welche die Untersuchungsfenster 24 freigeben. Die Durchbrüche 22 sind mit Punkten in Teilbereichen des ersten Halteelements 18a angedeutet. Die Zugangsöffnungen 30 des Dichtelements 28 sind vakuumdicht verschließbar. Zu diesem Zweck wird die Zugangsöffnung 30 beispielsweise mit einem vakuumfesten Klebstoff oder einem anderen geeigneten Dichtmittel verschlossen.

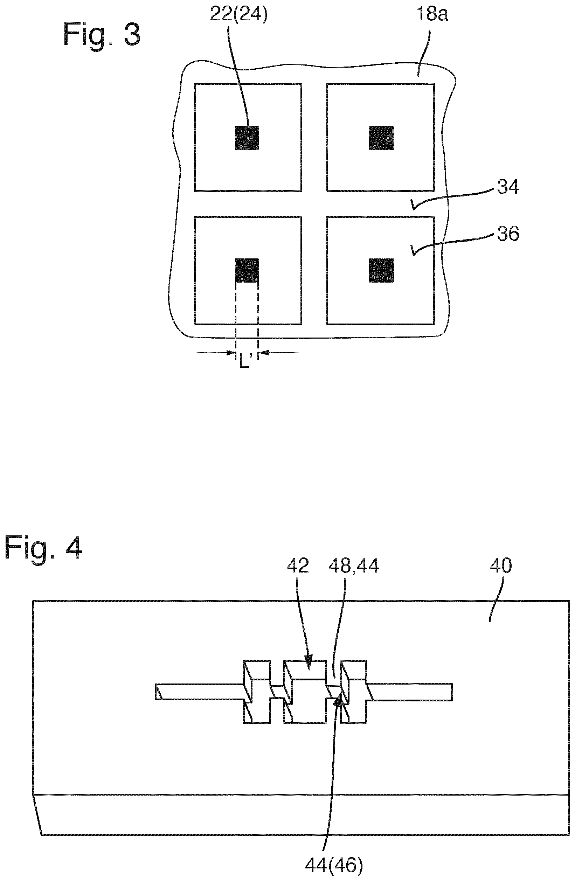

Die in Fig. 3 gezeigte Detailansicht zeigt wiederum eine Draufsicht auf das erste Halteelement 18a. Dieses ist aus Stegen 32 aufgebaut (vgl. auch Fig. 1), auf deren obere Stirnseite 34 der Blick in Fig. 3 gerichtet ist. Das erste Halteelement 18a ist beispielsweise aus Silizium hergestellt. Die Durchbrüche 22, von denen in Fig. 3 lediglich ein einziger mit Bezugszeichen versehen ist, werden beispielsweise photolithographisch hergestellt. Aufgrund dieses Herstellungsverfahrens ergibt sich die in Fig. 1 gezeigte typische im Querschnitt trapezförmige Struktur der Stege 32. Die Flanken 36 der Stege 32 sind in Fig. 3 mit punktierter Schraffur dargestellt.

Die Probenzelle 2 gemäß den dargestellten Ausführungsbeispielen ist mit Abstandshaltern bzw. Abstandselementen 14 versehen, welche betrachtet in einer Richtung R quer zu den großen Flachseiten 6a, 6b des Probenraums 4 eine zumindest näherungsweise identische Materialstärke aufweisen. Mit anderen Worten sind also alle den Abstandshalter 12 bildenden Abstandselemente 14 (Gleiches gilt auch für das Dichtelement 28, sofern dieses einen Teil des Abstandshalters 12 bildet) mit konstanter gleicher Materialstärke ausgeführt. Der Abstandshalter 12 definiert den Abstand d zwischen den Innenseiten 8a, 8b der Membranen 10a, 10b und damit eine Dicke der Probe 26, bei der es sich beispielsweise um einen Kristall, ferner beispielsweise um einen Einkristall handelt. Die konstante Materialstärke der Abstandselemente 14 führt dazu, dass die Innenseiten 8a, 8b der Membranen 10a, 10b zumindest näherungsweise planparallel zueinander angeordnet sind. Dies wiederum führt dazu, dass ein in dem Probenraum 4 vorhandener Kristall flach wächst und eine sehr homogene Dicke aufweist.

Um in dem Probenraum 4 einen Kristall, insbesondere einen Einkristall, als Probe 26 bereitzustellen, wird beispielsweise eine kristallisationsfähige Lösung durch die Zugangsöffnungen 30 in den Probenraum 4 eingebracht. Die kristallisationsfähige Lösung kristallisiert innerhalb des Probenraums 4 beispielsweise zu einem Einkristall, welcher anschließend mittels Röntgendiffraktometrie untersucht werden kann.

Eine Probenzelle 2 gemäß weiterer Ausführungsbeispiele umfasst einen Probenraum 4, dessen Aspektverhältnis zwischen einer lateralen Ausdehnung L, gemessen in einer Richtung zumindest näherungsweise parallel zu den großen Flachseiten 6a, 6b, und einer Dicke, die dem Abstand d der Membranen 10a, 10b entspricht, also in der Richtung R zumindest näherungsweise senkrecht zu den großen Flachseiten 6a, 6b gemessen wird, im Verhältnis von zumindest 10:1 steht. Mit anderen Worten ist der Probenraum 4 zumindest zehnmal so groß in lateraler Richtung wie in der dazu senkrechten Richtung, in der dieser durchstrahlt wird. Die laterale Ausdehnung L wird bei einer Probenzelle 2, die, wie in Fig. 2 beispielhaft dargestellt, einen quadratischen Probenraum 4 umfasst, als Kantenlänge gemessen.

Der Probenraum 4 weist eine laterale Ausdehnung L auf, die zwischen 100 µm und 100 mm liegt. Eine Dicke des Probenraums 4 liegt zwischen 1 nm und 10 µm. Die Untersuchungsfenster 24 weisen eine laterale Abmessung L`, die ebenso wie die laterale Ausdehnung L des Probenraums 4 gemessen wird, in einer Richtung zumindest näherungsweise parallel zu den großen Flachseiten 6a, 6b, auf, die zwischen 50 µm und 200 µm liegt. Auch die laterale Abmessung L' der Untersuchungsfenster 24 wird als Kantenlänge gemessen, sofern es sich, wie in dem Ausführungsbeispiel der Fig. 3, beispielhaft um quadratische Untersuchungsfenster 24 handelt. Im Übrigen gilt das zur Abmessung des Probenraums 4 Gesagte.

Fig. 4 zeigt in einer schematisch vereinfachten perspektivischen Darstellung eine Beladestation 40, die zur Aufnahme zumindest einer Probenzelle 2 nach einem oder mehreren der zuvor genannten Ausführungsbeispiel eingerichtet ist. Die Beladestation 40 umfasst ein Präparationsreservoir 42, welches als Vertiefung in der als Block ausgeführten Beladestation 40 vorgesehen ist. Die Wandungen des Präparationsreservoirs 42 bilden abschnittsweise einen Probenzellenhalter 44. Beispielhaft bilden bei dem in Fig. 4 dargestellten Ausführungsbeispiel die seitlichen Stirnseiten 46 der Fortsätze 48 den Probenzellenhalter 44 aus. Das Präparationsreservoir 42 ist geodätisch tiefer angeordnet als der Probenzellenhalter 44. Der Probenzellenhalter 44 ist ferner dazu eingerichtet, die Probenzelle 2 derart aufzunehmen, dass ein fluidischer Kontakt zwischen einem Teilbereich der Probenzelle 2 und dem Präparationsreservoir 42 herstellbar ist.

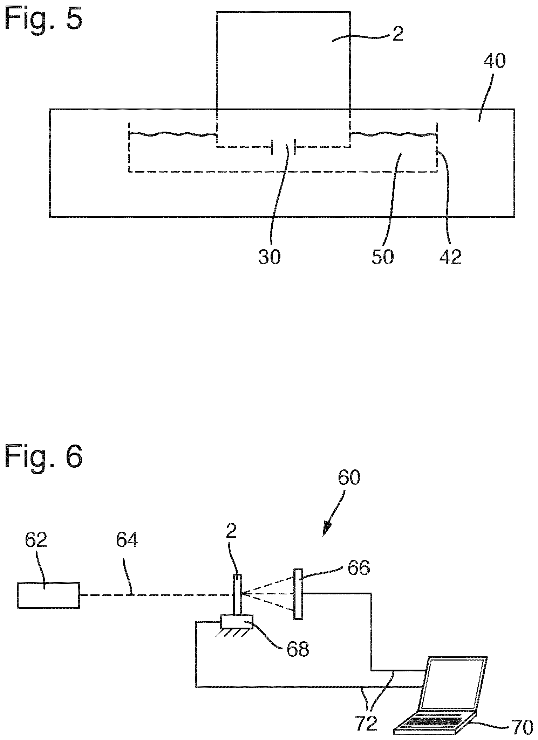

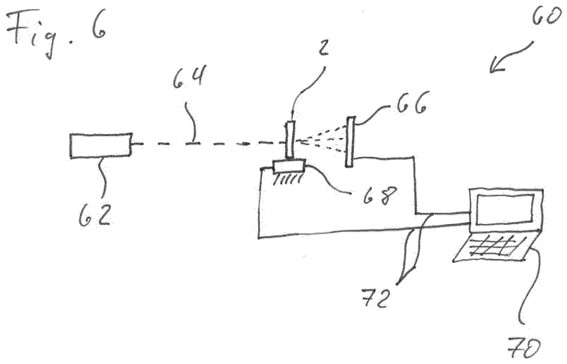

Fig. 5 zeigt in einer stark schematisch vereinfachten Seitenansicht die Beladestation 40 mit darin eingesetzter Probenzelle 2. In dem Präparationsreservoir 42 befindet sich beispielhaft eine Probenlösung 50 oder eine Suspension, insbesondere eine kristallisationsfähige Probenlösung 50 oder Suspension. Es ist auch vorgesehen, dass die Probenlösung 50 oder Suspension direkt in dem Präparationsreservoir 42 hergestellt wird. Der Probenzellenhalter 44 ist dazu eingerichtet, die Probenzelle 2 derart aufzunehmen, dass zwischen deren Zugangsöffnung 30 und dem Präparationsreservoir 42, respektive der in dem Präparationsreservoir 42 vorhandenen Probenlösung 50, ein fluidischer Kontakt herstellbar ist. Zu diesem Zweck wird die Probenzelle 2 so tief in das Präparationsreservoir 42 eingetaucht, bis die Zugangsöffnung 30 der Probenzelle 2 im fluidischen Kontakt mit der Probenlösung 50 steht.

Die Probenlösung 50 wird in den Probenraum 4 durch Kapillarkräfte entgegen der Schwerkraftrichtung eingesogen. Nach dem Beladen der Probenzelle 2 kann die Zugangsöffnung 30 verschlossen werden. Erfolgt eine direkte Untersuchung der Probe 26, ist es also nicht erforderlich, die Probe 26 über längere Zeit stabil zu halten, kann ein Verschluss der Zugangsöffnung 30 unterbleiben.

Fig. 6 zeigt in stark schematisch vereinfachter Darstellung eine Messvorrichtung 60 zum Untersuchen einer Probe 26, welche in dem Probenraum 4 einer Probenzelle 2 gemäß einem Ausführungsbeispiel vorhanden ist. Die Messvorrichtung 60 umfasst eine Strahlungsquelle 62, welche einen Messstrahl 64 emittiert. Bei der Strahlungsquelle 62 handelt es sich beispielsweise um eine elektromagnetische Strahlungsquelle, wie eine Röntgenquelle, oder auch um eine Elektronenstrahlstrahlungsquelle. Der Messstrahl 64 ist auf einen Teilbereich der Probenzelle 2 gerichtet und trifft diese insbesondere im Bereich eines Untersuchungsfensters 24. Die Messvorrichtung 60 umfasst ferner einen Detektor 66, welcher zur Erfassung von Messdaten, insbesondere zur Erfassung eines Elektronenbeugungsbilds oder eines Röntgenbeugungsbildes eingerichtet ist. Um verschiedene Untersuchungsfenster 24 der Probenzelle 2 zu untersuchen, ist diese auf einem verfahrbaren Probenhalter 68, beispielsweise einem Verfahrtisch, angeordnet.

Die Messvorrichtung 60 umfasst ferner eine Verarbeitungseinheit 70, beispielsweise einen PC, welche dazu eingerichtet ist, den Probenhalter 68 derart zu verfahren, dass mittels des Messstrahls 64 die Probe 26, welche sich innerhalb der Probenraums 4 der Probenzelle 2 befindet, an voneinander verschiedenen Bereichen in jeweils einem Untersuchungsfenster 24 der Probenzelle 2 vermessen wird. Die Verarbeitungseinheit 70 ist insbesondere dazu eingerichtet, den Probenhalter 68 derart zu verfahren, dass der Messstrahl 64 nacheinander auf verschiedene Untersuchungsfenster 24 der Probenzelle 2 trifft. Zu diesem Zweck ist die Verarbeitungseinheit 70, welche auch zum Auslesen des Detektors 66 dient, über geeignete Datenverbindungen 72 mit den vorgenannten Einheiten verbunden. Ein Verfahren zum Untersuchen eines flachen Kristalls, welcher beispielsweise als Probe 26 im Probenraum 4 der Probenzelle 2 vorliegt, umfasst gemäß einem Ausführungsbeispiel die folgenden Schritte:

Es wird zunächst eine Probenzelle 2 gemäß einem Ausführungsbeispiel bereitgestellt. Eine kristallisationsfähige Probenlösung 50, eine Suspension, beispielsweise eine Flüssigkeit mit darin enthaltenen Kristallen oder Kristalliten oder eine in anderer Weise in flüssiger Form vorliegende Probe wird in den Probenraum 4 der Probenzelle 2 verbracht, dies erfolgt beispielsweise unter Verwendung der Beladestation 40. Sofern eine kristallisationsfähige Flüssigkeit in die Probenzelle 2 eingebracht wird, wird die gefüllte Probenzelle 2 in einem Kristallisationsraum Umgebungsbedingungen ausgesetzt, welche eine Kristallbildung der kristallisationsfähigen Probenlösung 50 begünstigen. Umgebungsbedingungen, welche den Kristallisationsprozess begünstigen, sind beispielsweise bestimmte Temperaturen oder bestimmte Luftfeuchtigkeiten. Es ist ebenso vorgesehen, dass die Probenzelle 2 lediglich den üblichen Umgebungsbedingungen/Laborbedingungen ausgesetzt wird, sofern diese für die Kristallbildung ausreichend sind. In diesem Fall entspricht der Laborraum dem Kristallisationsraum. Anschließend wird die Probenzelle 2, welche nun zumindest einen Kristall, beispielsweise einen Einkristall, in ihrem Probenraum 4 umfasst, in eine Messvorrichtung 60 verbracht, welche eine Strahlungsquelle 62 umfasst, die einen Messstrahl 64 emittiert. Wie bereits zuvor mehrfach erwähnt, handelt es sich bei der Strahlungsquelle 62 beispielsweise um eine Röntgenstrahlungsquelle oder eine Elektronenstrahlungsquelle. Die Probenzelle 2 wird in Bezug auf den Messstrahl 64 ausgerichtet, dies erfolgt beispielsweise mithilfe des Probenhalters 68. Die Ausrichtung erfolgt derart, dass jeweils ein Teilbereich der Probenzelle 2 durchstrahlt wird und unter Verwendung eines Detektors 66 beispielsweise ein Elektronenbeugungsbild aufgenommen werden kann. Die Durchstrahlung der Probenzelle 2 erfolgt im Bereich ihrer Untersuchungsfenster 24.

Ein Verfahren zum Herstellen eines flachen Kristalls, insbesondere eines Einkristalls, welcher ebenfalls in einer Messvorrichtung 60, wie sie schematisch vereinfacht Fig. 6 zeigt, aber auch in einer anderen geeigneten Messvorrichtung untersucht werden kann, umfasst gemäß einem Ausführungsbeispiel die folgenden Schritte:

Wiederum wird zunächst eine Probenzelle 2 gemäß einem Ausführungsbeispiel bereitgestellt. Es wird erneut eine kristallisationsfähige Probenlösung 50 in den Probenraum 4 der Probenzelle 2 verbracht. Die gefüllte Probenzelle 2 wird erneut in einem Kristallisationsraum unter Umgebungsbedingungen, die die Kristallbildung der kristallisationsfähigen Probenlösung 50 begünstigen, für einen ausreichenden Zeitraum gehalten. Nachdem sich ein Kristall, beispielsweise ein Einkristall, in dem Probenraum 4 der Probenzelle 2 gebildet hat, wird die erste Membran 10a einschließlich des ersten Halteelements 18a und/oder die zweite Membran 10b einschließlich des zweiten Halteelements 18b entfernt. Auf diese Weise wird der Probenraum 4 geöffnet. Der in dem Probenraum 4 vorhandene Kristall, beispielsweise ein Einkristall, kann in der halb geöffneten Probenzelle 2 untersucht werden. Es ist auch vorgesehen, den in dem Probenraum 4 vorhandenen Einkristall zu entnehmen und einer Messung zuzuführen. Auch vorgesehen ist, nach beidseitiger Entfernung der Membranen 10a, 10b einschließlich der Halteelemente 18a, 18b den Kristall, lediglich gehalten durch das Dichtelement 28, beispielsweise in Transmission, zu untersuchen.

Die Probenzelle 2 kann also vorteilhaft zum Züchten eines flachen Kristalls, insbesondere eines Einkristalls, in dem Probenraum 4 verwendet werden.

### Bezugszeichenliste

- 2: Probenzelle
- 4: Probenraum
- 6a: erste große Flachseite
- 6b: zweite große Flachseite
- 8a: erste Innenseite
- 8b: zweite Innenseite
- 10a: erste Membran
- 10b: zweite Membran
- 12: Abstandshalter
- 14: Abstandselement
- 16a: erste Außenseite
- 16b: zweite Außenseite
- 18a: erstes Halteelement
- 18b: zweites Halteelement
- 20: Haltestruktur
- 22: Durchbruch
- 24: Untersuchungsfenster
- 26: Probe
- 28: Dichtelement
- 30: Zugangsöffnung
- 32: Steg
- 34: Stirnseiten
- 36: Flanken
- 40: Beladestation
- 42: Präparationsreservoir
- 44: Probenzellenhalter
- 46: seitliche Stirnseiten
- 48: Fortsätze
- 50: Probenlösung
- 60: Messvorrichtung
- 62: Strahlungsquelle
- 64: Messstrahl
- 66: Detektor
- 68: Probenhalter
- 70: Verarbeitungseinheit
- 72: Datenverbindungen

- d: Abstand
- L: laterale Ausdehnung
- L': laterale Abmessung
- R: Richtung

## Patentansprüche

1. Probenzelle (2), umfassend zumindest einen flachen Probenraum (4), welcher an seiner ersten großen Flachseite (6a) von einer ersten Innenseite (8a) einer ersten Membran (10a) und an seiner zweiten großen Flachseite (6b) von einer zweiten Innenseite (8b) einer zweiten Membran (10b) begrenzt ist, wobei zwischen der ersten und der zweiten Innenseite (8a, 8b) ein Abstandshalter (12) angeordnet ist, der einen Abstand zwischen den beiden Membranen (10a, 10b) festlegt, und wobei an einer dem Probenraum (4) abgewandten ersten Außenseite (16a) der ersten Membran (10a) ein erstes Halteelement (18a) und an einer dem Probenraum (4) abgewandten zweiten Außenseite (16b) der zweiten Membran (10b) ein zweites Halteelement (18b) angeordnet sind und das erste und zweite Halteelement (18a, 18b) gemeinsam eine Haltestruktur (20) bilden, wobei das erste und zweite Halteelement (18a, 18b) jeweils eine Mehrzahl von Durchbrüchen (22) aufweisen, die in einer Richtung (R) quer zu den Flachseiten (6a, 6b) zueinander fluchtend angeordnet sind, so dass sich eine Mehrzahl von Untersuchungsfenstern (24) ergibt, in denen die Außenseiten (16a, 16b) der Membranen (10a, 10b) freiliegen.

2. Probenzelle (2) nach Anspruch 1, bei der die erste Innenseite (8a) der ersten Membran (10a) mit dem Abstandshalter (12), die erste Außenseite (16a) der ersten Membran (10a) mit dem ersten Halteelement (18a), die zweite Innenseite (8b) der zweiten Membran (10b) mit dem Abstandshalter (12) und/oder die zweite Außenseite (16b) der zweiten Membran (10b) mit dem zweiten Halteelement (18b) stoffschlüssig, insbesondere vakuumdicht, verbunden sind.

3. Probenzelle (2) nach Anspruch 1 oder 2, ferner umfassend ein Dichtelement (28), welches sich zwischen der ersten Innenseite (8a) der ersten Membran (10a) und der zweiten Innenseite (8b) der zweiten Membran (10b) in einem Randbereich erstreckt und den zumindest einen Probenraum (4) gegenüber einem Außenraum abschließt, wobei das Dichtelement (28) zumindest eine Zugangsöffnung (30) freilässt, durch die der zumindest eine Probenraum (4) befüllbar ist.

4. Probenzelle (2) nach einem der Ansprüche 1 bis 3, bei der der Abstandshalter (12), betrachtet in einer Richtung (R) quer zu den großen Flachseiten (6a, 6b), eine konstante Materialstärke aufweist, so dass die Innenseiten (8a, 8b) der Membranen (10a, 10b) zumindest näherungsweise planparallel zueinander angeordnet sind.

5. Probenzelle (2) nach einem der Ansprüche 1 bis 4, deren zumindest einer Probenraum (4) ein Aspektverhältnis zwischen einer lateralen Ausdehnung (L), gemessen in einer Richtung (R) zumindest näherungsweise parallel zu den großen Flachseiten (6a, 6b), und einer Dicke (d), gemessen in einer Richtung (R) zumindest näherungsweise senkrecht zu den großen Flachseiten (6a, 6b), von zehn zu eins (10:1) oder größer aufweist.

6. Probenzelle (2) nach einem der Ansprüche 1 bis 5, deren zumindest einer Probenraum (4) laterale Ausdehnungen (L), gemessen in einer Richtung (R) zumindest näherungsweise parallel zu den großen Flachseiten (6a, 6b), zwischen 100 µm und 100 mm aufweist und deren zumindest einer Probenraum (4) eine Dicke (d), gemessen in einer Richtung (R) zumindest näherungsweise senkrecht zu den großen Flachseiten (6a, 6b), zwischen 1 nm und 10 µm aufweist.

7. Probenzelle (2) nach einem der Ansprüche 1 bis 6, bei der die Untersuchungsfenster (24) eine laterale Abmessung (L'), betrachtet in einer Richtung (R) zumindest näherungsweise parallel zu den großen Flachseiten (6a, 6b), aufweisen, die zwischen 10 µm und 200 µm liegt.

8. Beladestation (40) zur Aufnahme von einer Probenzelle (2) nach einem der Ansprüche 1 bis 7, umfassend ein Präparationsreservoir (42) und einen Probenzellenhalter (44), wobei das Präparationsreservoir (42) geodätisch tiefer angeordnet ist als der Probenzellenhalter (44), der dazu eingerichtet ist, die Probenzelle (2) derart aufzunehmen, dass ein fluidischer Kontakt zwischen einem Teilbereich der Probenzelle (2) und dem Präparationsreservoir (42) herstellbar ist.

9. Beladestation (40) nach Anspruch 8 zur Aufnahme einer Probenzelle (2) nach einem der Ansprüche 3 bis 7, bei dem der Probenzellenhalter (44) dazu eingerichtet ist, die zumindest eine Probenzelle (2) derart aufzunehmen, dass zwischen deren zumindest einer Zugangsöffnung (30) und dem Präparationsreservoir (42) ein fluidischer Kontakt herstellbar ist.

10. Messvorrichtung (60) zum Untersuchen einer Probe (26), welche in dem einen Probenraum (4) einer Probenzelle (2) nach einem der Ansprüche 1 bis 7 vorhanden ist, umfassend eine Strahlungsquelle (62), welche einen Messstrahl (64) emittiert, der auf einen Teilbereich der Probenzelle (2) gerichtet ist, und einen Detektor (66) zur Erfassung einer Messung, insbesondere zum Messen eines Elektronenbeugungsbildes.

11. Verfahren zum Untersuchen einer flachen Probe, die folgenden Schritte umfassend:
a) Bereitstellen einer Probenzelle (2) nach einem der Ansprüche 1 bis 7,
b) Verbringen einer Probenlösung oder Suspension (50) in den zumindest einen Probenraum (4) der Probenzelle (2),
c) Verbringen der Probenzelle (2), welche die flache Probe in dem zumindest einen Probenraum (4) umfasst, in eine Messvorrichtung (60), umfassend eine Strahlungsquelle, insbesondere eine Elektronenquelle (62), welche einen Messstrahl (64) emittiert,
d) Ausrichten der Probenzelle (2) in Bezug auf den Messstrahl (64), so dass dieser zumindest einen Teil der Probe, die in einen Teilbereich des Probenraums (4) der Probenzelle (2) vorhanden ist, durchstrahlt, und
e) Aufnehmen einer Messung, insbesondere eines Elektronenbeugungsbildes, der Probe.

12. Verfahren nach Anspruch 11 zum Untersuchen eines flachen Kristalls als Probe, bei dem
in Schritt b) eine kristallisationsfähige Probenlösung (50) in den Probenraum (4) der Probenzelle (2) verbracht wird,
das Verfahren zusätzlich den nach Schritt b) auszuführenden Schritt b1) umfasst:
b1) Verbringen der gefüllten Probenzelle (2) in einen Kristallisationsraum und Bereitstellen von Umgebungsbedingungen in dem Kristallisationsraum, die eine Kristallbildung in der kristallisationsfähigen Probenlösung (50) begünstigen.

13. Verfahren zum Herstellen eines flachen Kristalls, insbesondere eines Einkristalls, die folgenden Schritte umfassend:
Bereitstellen einer Probenzelle (2) nach einem der Ansprüche 1 bis 7,
Verbringen einer kristallisationsfähigen Probenlösung (50) in den Probenraum (4) der Probenzelle (2),
Verbringen der gefüllten Probenzelle (2) in einen Kristallisationsraum und Bereitstellen von Umgebungsbedingungen in dem Kristallisationsraum, die eine Kristallbildung in der kristallisationsfähigen Probenlösung (50) begünstigen,
nachdem sich der Kristall, insbesondere der Einkristall, in dem Probenraum (4) gebildet hat, Entfernen der ersten und/oder der zweiten Membran (10a, 10b) einschließlich des zugehörigen Halteelements (18a, 18b) und Entnehmen des Kristalls aus dem geöffneten Probenraum (4).

14. Verwendung einer Probenzelle (2) nach einem der Ansprüche 1 bis 7 zum Züchten eines flachen Kristalls, insbesondere eines Einkristalls, in dem Probenraum (4), ferner insbesondere nach einem Verfahren nach Anspruch 13.

15. Verwendung einer Probenzelle (2) nach einem der Ansprüche 1 bis 7 zum Durchführen einer Messung nach einem Verfahren gemäß Anspruch 11 oder 12.

## Claims

1. A sample cell (2), comprising at least one flat sample space (4), which is restricted on its first large flat side (6a) by a first inner side (8a) of a first membrane (10a) and on its second large flat side (6b) by a second inner side (8b) of a second membrane (10b), wherein a spacer (12) is arranged between the first and the second inner sides (8a, 8b), which spacer (12) establishes a distance between the two membranes (10a, 10b), and wherein a first retaining element (18a) is arranged on a first outer side (16a), which faces away from the sample space (4), of the first membrane (10a) and a second retaining element (18b) is arranged on a second outer side (16b), which faces away from the sample space (4), of the second membrane (10b), and the first and second retaining elements (18a, 18b) together form a retaining structure (20), wherein the first and second retaining elements (18a, 18b) each have a plurality of apertures (22), which are arranged to align with each other in a direction (R) transverse to the flat sides (6a, 6b), in that a plurality of examination windows (24) result, in which the outer sides (16a, 16b) of the membranes (10a, 10b) are exposed.

2. The sample cell (2) according to claim 1, in which the first inner side (8a) of the first membrane (10a) is connected to the spacer (12), the first outer side (16a) of the first membrane (10a) is connected to the first retaining element (18a), the second inner side (8b) of the second membrane (10b) is connected to the spacer (12), and/or the second outer side (16b) of the second membrane (10b) is connected to the second retaining element (18b) in a firmly bonded manner, in particular vacuum-tight.

3. The sample cell (2) according to claim 1 or 2, further comprising a sealing element (28), which extends between the first inner side (8a) of the first membrane (10a) and the second inner side (8b) of the second membrane (10b), in an edge region and seals off the at least one sample space (4) from an outer space, wherein the sealing element (28) leaves at least one access opening (30) free, through which the at least one sample space (4) can be filled.

4. The sample cell (2) according to one of claims 1 to 3, in which the spacer (12), viewed in a direction (R) transverse to the large flat sides (6a, 6b), has a constant material thickness so that the inner sides (8a, 8b) of the membranes (10a, 10b) are arranged at least approximately plane-parallel to each other.

5. The sample cell (2) according to one of claims 1 to 4, the at least one sample space (4) of which has an aspect ratio between a lateral extent (L), measured in a direction (R) at least approximately parallel to the large flat sides (6a, 6b), and a thickness (d), measured in a direction (R) at least approximately perpendicular to the large flat sides (6a, 6b), of ten to one (10:1) or greater.

6. The sample cell (2) according to one of claims 1 to 5, the at least one sample space (4) of which has lateral extents (L), measured in a direction (R) at least approximately parallel to the large flat sides (6a, 6b), between 100 µm and 100 mm and the at least one sample space (4) of which has a thickness (d), measured in a direction (R) at least approximately perpendicular to the large flat sides (6a, 6b), between 1 nm and 10 µm.

7. The sample cell (2) according to one of claims 1 to 6, in which the examination windows (24) have a lateral dimension (L'), viewed in a direction (R) at least approximately parallel to the large flat sides (6a, 6b), which is between 10 µm and 200 µm.

8. A loading station (40) for receiving a sample cell (2) according to one of claims 1 to 7, comprising a preparation reservoir (42) and a sample cell holder (44), wherein the preparation reservoir (42) is arranged geodetically deeper than the sample cell holder (44), which is configured to receive the sample cell (2) such that a fluid contact can be established between a subregion of the sample cell (2) and the preparation reservoir (42).

9. The loading station (40) according to claim 8 for receiving a sample cell (2) according to one of claims 3 to 7, in which the sample cell holder (44) is configured to receive the at least one sample cell (2) such that a fluid contact can be established between its at least one access opening (30) and the preparation reservoir (42).

10. A measuring device (60) for examining a sample (26) which is present in the sample space (4) of a sample cell (2) according to one of claims 1 to 7, comprising a radiation source (62) which emits a measurement beam (64) which is aimed at a subregion of the sample cell (2), and a detector (66) for detecting a measurement, in particular for measuring an electron diffraction image.

11. A method for examining a flat sample, comprising the following steps:
a) Providing a sample cell (2) according to one of claims 1 to 7,
b) Introducing a sample solution or suspension (50) into the at least one sample space (4) of the sample cell (2),
c) Introducing the sample cell (2), which comprises the flat sample in the at least one sample space (4), into a measuring device (60), comprising a radiation source, in particular an electron source (62), which emits a measurement beam (64),
d) Aligning the sample cell (2) in relation to the measurement beam (64) so that the beam irradiates at least a part of the sample which is present in a subregion of the sample space (4) of the sample cell (2), and
e) Recording a measurement, in particular an electron diffraction image, of the sample.

12. The method according to claim 11 for examining a flat crystal as a sample, in which
in step b), a crystallizable sample solution (50) is introduced into the sample space (4) of the sample cell (2),
the method additionally comprises step b1) to be executed after step b):
b1) Introducing the filled sample cell (2) into a crystallization space and providing ambient conditions in the crystallization space that are favorable for crystal formation in the crystallizable sample solution (50).

13. A method for producing a flat crystal, in particular a monocrystal, comprising the following steps:
Providing a sample cell (2) according to one of claims 1 to 7,
Introducing a crystallizable sample solution (50) into the sample space (4 ) of the sample cell (2),
Introducing the filled sample cell (2) into a crystallization space and providing ambient conditions in the crystallization space that are favorable for crystal formation in the crystallizable sample solution (50), After the crystal, in particular the monocrystal, has formed in the sample space (4), removing the first and/or the second membrane (10a, 10b) including the corresponding retaining element (18a, 18b) and removing the crystal from the opened sample space (4).

14. A use of a sample cell (2) according to one of claims 1 to 7 for growing a flat crystal, in particular a monocrystal, in the sample space (4), further particularly according to a method according to claim 13.

15. The use of a sample cell (2) according to one of claims 1 to 7 for performing a measurement according to a method according to claim 11 to 12.

## Revendications

1. Cellule échantillon (2), comprenant au moins un espace d'échantillon plat (4), lequel est limité sur son premier grand côté plat (6a) par un premier côté intérieur (8a) d'une première membrane (10a) et sur son deuxième grand côté plat (6b) par un deuxième côté intérieur (8b) d'une deuxième membrane (10b), un espaceur (12) étant disposé entre les premier et deuxième côtés intérieurs (8a, 8b), lequel spécifie un espace entre les deux membranes (10a, 10b), et un premier élément de maintien (18a) étant disposé sur un premier côté extérieur (16a) de la première membrane (10a) tourné à l'opposé de l'espace d'échantillon (4) et un deuxième élément de maintien (18b) étant disposé sur un deuxième côté extérieur (16b) de la deuxième membrane (10b) tourné à l'opposé de l'espace d'échantillon (4), et les premier et deuxième éléments de maintien (18a, 18b) formant conjointement une structure de maintien (20), les premier et deuxième éléments de maintien (18a, 18b) présentant respectivement une multiplicité de passages (22), lesquels sont disposés dans une direction (R) transversalement par rapport aux côtés plats (6a, 6b) de façon alignée l'un par rapport à l'autre de telle sorte qu'une multiplicité de fenêtres d'inspection (24) dans lesquelles les côtés extérieurs (16a, 16b) des membranes (10a, 10b) sont exposés en résulte.

2. Cellule d'échantillon (2) selon la revendication 1, sur laquelle le premier côté intérieur (8a) de la première membrane (10a) est reliée avec l'espaceur (12) par liaison de matière, en particulier de façon étanche au vide, le premier côté extérieur (16a) de la première membrane (10a) est relié avec le premier élément de maintien (18a) par liaison de matière, en particulier de façon étanche au vide, le deuxième côté intérieur (8b) de la deuxième membrane (10b) est relié avec l'espaceur (12) par liaison de matière, en particulier de façon étanche au vide et/ou le deuxième côté extérieur (16b) de la deuxième membrane (10b) est relié avec le deuxième élément de maintien (18b) par liaison de matière, en particulier de façon étanche au vide.

3. Cellule échantillon (2) selon la revendication 1 ou 2, comprenant en outre un élément d'étanchéité (28), lequel s'étend entre le premier côté intérieur (8a) de la première membrane (10a) et le deuxième côté intérieur (8b) de la deuxième membrane (10b) dans une zone de bord et ferme l'au moins un espace d'échantillon (4) par rapport à un espace extérieur, l'élément d'étanchéité (28) laissant dégagée au moins une ouverture d'accès (30) par laquelle l'au moins un espace d'échantillon (4) peut être rempli.

4. Cellule échantillon (2) selon l'une des revendications 1 à 3, sur laquelle l'espaceur (12), considéré dans une direction (R) transversalement par rapport aux grands côtés plats (6a, 6b) présente une épaisseur de matériau constante de telle sorte que les côtés intérieurs (8a, 8b) des membranes (10a, 10b) sont disposés au moins approximativement avec plans parallèles l'un par rapport à l'autre.

5. Cellule échantillon (2) selon l'une des revendications 1 à 4, dont l'au moins un espace d'échantillon (4) présente un rapport de forme de 10 à 1 (10:1) ou plus entre une étendue latérale (L), mesurée dans une direction (R) de façon au moins approximativement parallèle aux grands côtés plats (6a, 6b) et une épaisseur (d), mesurée dans une direction (R) de façon au moins approximativement verticale par rapport aux grands côtés plats (6a, 6b).

6. Cellule échantillon (2) selon l'une des revendications 1 à 5, dont l'au moins un espace d'échantillon (4) présente des étendues latérales (L) entre 100 µm et 100 mm, mesurées dans une direction (R) de façon au moins approximativement parallèle aux grands côtés plats (6a, 6b), et dont l'au moins un espace d'échantillon (4) présente une épaisseur (d) entre 1 nm et 10 µm, mesurée dans une direction (R) de façon au moins approximativement verticale par rapport aux grands côtés plats (6a, 6b).

7. Cellule échantillon (2) selon l'une des revendications 1 à 6, sur laquelle les fenêtres d'inspection (24) présentent une mesure latérale (L') qui se trouve entre 10 µm et 200 µm, considérée dans une direction (R) de façon au moins approximativement parallèle aux grands côtés plats (6a, 6b).

8. Station de charge (40) pour l'accueil d'une cellule échantillon (2) selon l'une des revendications 1 à 7, comprenant un réservoir de préparation (42) et un support de cellule échantillon (44), le réservoir de préparation (42) étant disposé plus bas, géodésiquement, que le support de cellule échantillon (44), lequel est configuré pour accueillir la cellule échantillon (2) de telle sorte qu'un contact fluidique peut être établi entre une zone partielle de la cellule échantillon (2) et le réservoir de préparation (42).

9. Station de charge (40) selon la revendication 8 pour l'accueil d'une cellule échantillon (2) selon l'une des revendications 3 à 7, sur laquelle le support de cellule échantillon (44) est configuré pour accueillir l'au moins une cellule échantillon (2) de telle sorte qu'un contact fluidique peut être établi entre l'au moins une ouverture d'accès (30) et le réservoir de préparation (42).

10. Dispositif de mesure (60) pour l'inspection d'un échantillon (26), lequel est présent dans l'un espace d'échantillon (4) d'une cellule échantillon (2) selon l'une des revendications 1 à 7, comprenant une source de rayonnement (62), lequel émet un rayon de mesure (64) qui est dirigé sur une zone partielle de la cellule échantillon (2), et un détecteur (66) pour la détection d'une mesure, en particulier pour la mesure d'une image de diffraction d'électrons.

11. Procédé pour l'inspection d'un échantillon plat, comprenant les étapes suivantes :
a) fourniture d'une cellule échantillon (2) selon l'une des revendications 1 à 7,
b) dépôt d'une solution échantillon ou suspension (50) dans l'au moins un espace d'échantillon (4) de la cellule échantillon (2),
c) dépôt d'une cellule échantillon (2), laquelle comprend l'échantillon plat dans l'au moins un espace d'échantillon (4), dans un dispositif de mesure (60), comprenant une source de rayonnement, en particulier une source d'électrons (62), lequel émet un rayon de mesure (64),
d) orientation de la cellule échantillon (2) relativement au rayon de mesure (64), de telle sorte que celui-ci traverse au moins une partie de l'échantillon, lequel est présent dans une zone partielle de l'espace d'échantillon (4) de la cellule échantillon (2), et
e) enregistrement d'une mesure de l'échantillon, en particulier d'une image de diffraction d'électrons.

12. Procédé selon la revendication 11 pour l'inspection d'un cristal plat comme échantillon, sur lequel
à l'étape b), une solution échantillon (50) cristallisable est déposée dans l'espace d'échantillon (4) de la cellule échantillon (2),
le procédé comprenant en outre l'étape b1) devant être exécutée après l'étape b) :
b1) dépôt de la cellule échantillon (2) remplie dans un espace de cristallisation et fourniture des conditions ambiantes dans l'espace de cristallisation, lesquelles favorisent une formation de cristal dans la solution échantillon (50) cristallisable.

13. Procédé pour la fabrication d'un cristal plat, en particulier d'un monocristal, comprenant les étapes suivantes :
fourniture d'une cellule échantillon (2) selon l'une des revendications 1 à 7,
dépôt d'une solution échantillon (50) cristallisable dans l'espace d'échantillon (4) de la cellule échantillon (2),
dépôt de la cellule échantillon (2) remplie dans un espace de cristallisation et fourniture des conditions ambiantes dans l'espace de cristallisation, lesquelles favorisent une formation de cristal dans la solution échantillon (50) cristallisable, après que le cristal, en particulier le monocristal, s'est formé dans l'espace d'échantillon (4), enlèvement de la première membrane et/ou de la deuxième membrane (10a, 10b), y compris de l'élément de maintien (18a, 18b) correspondant et enlèvement du cristal hors de l'espace d'échantillon (4) ouvert.

14. Utilisation d'une cellule échantillon (2) selon l'une des revendications 1 à 7 pour la croissance d'un cristal plat, en particulier d'un monocristal, dans l'espace d'échantillon (4), en outre conformément à un procédé selon la revendication 13, en particulier.

15. Utilisation d'une cellule échantillon (2) selon l'une des revendications 1 à 7 pour l'exécution d'une mesure conformément à un procédé selon la revendication 11 ou 12.
